# EUROPEAN PATENT APPLICATION

(11) **EP 4 760 784 A1**
(43) Date of publication of application: **17.06.2026**
(21) Application number: 25184720.8
(22) Date of filing: 24.06.2025
(51) Int. Cl.: H01L 23/535, H01L 21/74, H01L 21/762, H01L 23/528, H10D 86/00, H01L 21/20, H01L 23/373

(54) **SEMICONDUCTOR STRUCTURES INCLUDING A CONDUCTOR LAYER AND MULTIPLE ISOLATION LAYERS**

(30) Priority: 10.12.2024 US 202418975041
(71) Applicant: GlobalFoundries U.S. Inc., Malta, NY 12020 (US)
(72) Inventor: Borisov, Kiril Biserov, 1700 Sofia (BG); Pritchard, David, Malta, 12020 (US); Ramadout, Benoit Francois Claude, 01109 Dresden (DE)
(74) Representative: Grünecker Patent- und Rechtsanwälte PartG mbB

(57) **Abstract**

Semiconductor structures that include a conductor layer and multiple dielectric layers, as well as methods of forming such semiconductor structures. The structure comprises a first dielectric layer, a second dielectric layer, and a conductor layer including a first section and a second section between the first dielectric layer and the second dielectric layer. The structure further comprises a semiconductor layer including a first section that overlaps with the first section of the conductor layer and a second section that overlaps with the second section of the conductor layer, and a trench isolation region including a first portion laterally between the first section of the conductor layer and the second section of the conductor layer.

## Description

### BACKGROUND

The disclosure relates to semiconductor device fabrication and integrated circuits and, more specifically, to semiconductor structures that include a conductor layer and multiple isolation layers, as well as methods of forming such semiconductor structures.

Devices fabricated using semiconductor-on-insulator technologies may exhibit certain performance improvements in comparison with comparable devices fabricated using a bulk silicon substrate. **In** general, a semiconductor-on-insulator substrate includes a thin semiconductor layer, a semiconductor substrate, and an insulator layer physically separating and electrically isolating the semiconductor layer from the semiconductor substrate. Integrated circuits may be fabricated using the semiconductor layer of the semiconductor-on-insulator substrate. Back-biasing in a semiconductor-on-insulator technology may be limited by parasitic diodes that occur in the semiconductor substrate.

Improved semiconductor structures that include a conductor layer and multiple isolation layers, as well as methods of forming such semiconductor structures, are needed.

### SUMMARY

**In** an embodiment of the invention, a structure comprises a first dielectric layer, a second dielectric layer, and a conductor layer including a first section and a second section between the first dielectric layer and the second dielectric layer. The structure further comprises a semiconductor layer including a first section that overlaps with the first section of the conductor layer and a second section that overlaps with the second section of the conductor layer, and a trench isolation region including a first portion laterally between the first section of the conductor layer and the second section of the conductor layer.

**In** an embodiment of the invention, a method comprises forming a layer stack including a first dielectric layer, a second dielectric layer, a conductor layer between the first dielectric layer and the second dielectric layer, and a semiconductor layer on the second dielectric layer. The method further comprises forming a trench isolation region that divides the conductor layer into a first section and a second section. The trench isolation region includes a first portion laterally between the first section of the conductor layer and the second section of the conductor layer. The semiconductor layer includes a first section that overlaps with the first section of the conductor layer and a second section that overlaps with the second section of the conductor layer.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals refer to like features in the various views.
FIG. 1 is a cross-sectional view of a structure at an initial fabrication stage of a processing method in accordance with embodiments of the invention.
FIG. 2 is a cross-sectional view of the structure at a fabrication stage of the processing method subsequent to FIG. 1.
FIG. 3 is a cross-sectional view of the structure at a fabrication stage of the processing method subsequent to FIG. 2.
FIG. 4 is a cross-sectional view of the structure at a fabrication stage of the processing method subsequent to FIG. 3.
FIG. 5 is a cross-sectional view of the structure at a fabrication stage of the processing method subsequent to FIG. 4.
FIG. 6 is a cross-sectional view of a structure in accordance with alternative embodiments of the invention.
FIG. 7 is a cross-sectional view of a structure in accordance with alternative embodiments of the invention.
FIG. 8 is a cross-sectional view of a structure in accordance with alternative embodiments of the invention.
FIG. 9 and 10 are cross-sectional views of a structure at successive stages of a fabrication method in accordance with alternative embodiments of the invention.

### DETAILED DESCRIPTION

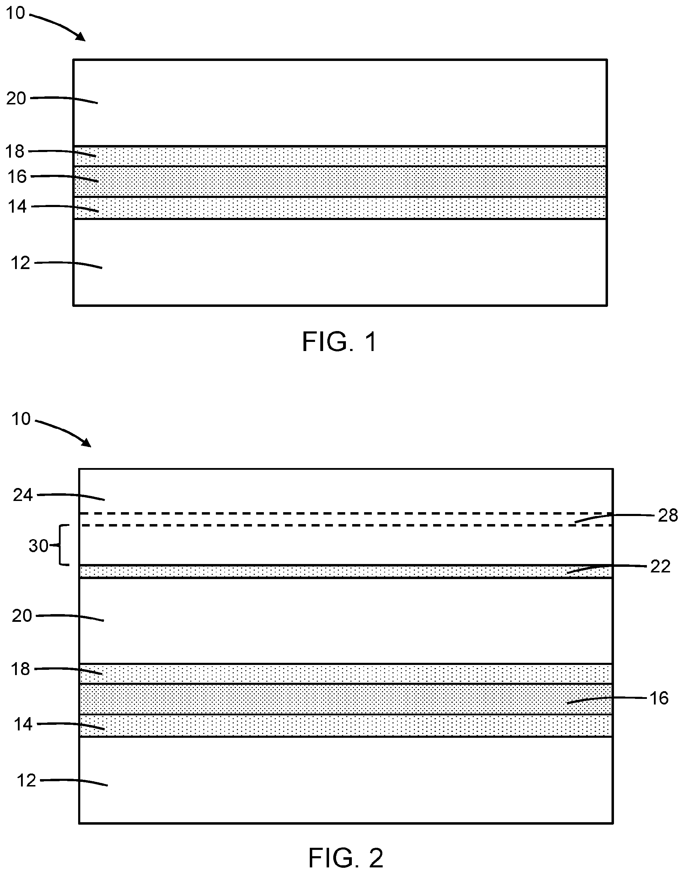

With reference to FIG. 1 and in accordance with embodiments of the invention, a structure 10 includes a substrate 12, a dielectric layer 14, a conductor layer 16, a dielectric layer 18, and a semiconductor layer 20. The dielectric layer 14, the conductor layer 16, the dielectric layer 18, and the semiconductor layer 20 are arranged in a layer stack on the substrate 12. The substrate 12 may be comprised of a single-crystal semiconductor material, such as single-crystal silicon. The semiconductor material of the substrate 12 may be lightly doped with a concentration of a p-type dopant (e.g., boron). The dielectric layer 14 is positioned on the substrate 12. The dielectric layer 14 may be comprised of a dielectric material, such as silicon dioxide, silicon nitride, or another oxide or nitride, that is an electrical insulator.

The conductor layer 16 is positioned on the dielectric layer 14. In an embodiment, the conductor layer 16 may be positioned in direct contact with the dielectric layer 14. The conductor layer 16 may be comprised of a conductor material, such as a metal or a metal nitride, that is electrically conductive. In an embodiment, the conductor layer 16 may be formed by depositing a layer of the conductor material on the dielectric layer 14. In an embodiment, the metal contained in the conductor layer 16 may be tungsten deposited by atomic layer deposition or chemical vapor deposition.

The dielectric layer 18 is positioned on the conductor layer 16. In an embodiment, the dielectric layer 18 may be positioned in direct contact with the conductor layer 16. The dielectric layer 18 may be comprised of a dielectric material that is an electrical insulator. In an embodiment, the dielectric layer 18 may be comprised of a dielectric material, such as silicon dioxide, silicon nitride, or another oxide or nitride, that is an electrical insulator. In an alternative embodiment, the dielectric layer 18 may be comprised of aluminum oxide that is an electrical insulator characterized by a comparatively high thermal conductivity.

The semiconductor layer 20 may be comprised of a semiconductor material, such as silicon. The semiconductor material of the semiconductor layer 20 may be grown by an epitaxial growth process and may be doped with a p-type dopant, such as boron, that provides p-type conductivity.

The conductor layer 16 is positioned between the dielectric layer 14 and the dielectric layer 18. The dielectric layer 14 is positioned between the conductor layer 16 and the substrate 12. The dielectric layer 14 functions as an isolation layer providing electrical isolation between the conductor layer 16 and the substrate 12. The dielectric layer 18 is positioned between the semiconductor layer 20 and the conductor layer 16. The dielectric layer 18 functions as an isolation layer providing electrical isolation between the conductor layer 16 and the semiconductor layer 20.

With reference to FIG. 2 and at a fabrication stage subsequent to FIG. 1, a dielectric layer 22 comprised of an oxide of silicon, such as silicon dioxide, may be formed as a coating on a top surface of a semiconductor substrate 24 by, for example, an oxidation process. The semiconductor substrate 24 may be comprised of a single-crystal semiconductor material, such as single-crystal silicon. The semiconductor substrate 24 may be ion implanted using an ion implantation process with hydrogen ions, or other rare gas ions, to create a damaged region of semiconductor material in a damaged band 28. The damaged band 28, after a suitable thermal treatment, may define a cleaving plane promoting subsequent separation of a semiconductor layer 30 between the dielectric layer 22 and the damaged band 28. The kinetic energy of the implanted hydrogen ions is selected to provide a projected range that establishes the depth of the damaged band 28. The stopped hydrogen will reside predominantly across the damaged band 28 in a distribution with a peak concentration, as well as a peak damage level, roughly centered about the projected range of the ions.

The top surface of the dielectric layer 22 may be placed in a face-to-face contacting relationship with the top surface of the semiconductor layer 20. The contacting surfaces of the dielectric layer 22 and the semiconductor layer 20 may be bonded together by a thermal bonding technique that may involve a high temperature anneal. After thermal bonding is completed, the dielectric layer 22 is positioned between the semiconductor substrate 24 and the semiconductor layer 20.

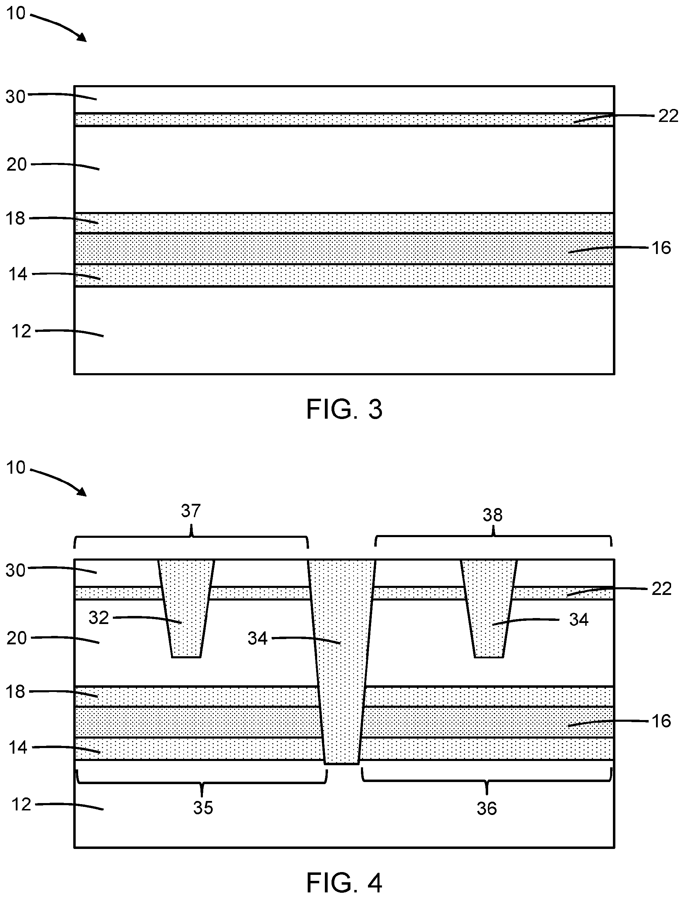

With reference to FIG. 3 and at a fabrication stage subsequent to FIG. 2, the semiconductor substrate 24 may be cleaved along the cleaving plane at the location of the damaged band 28. The semiconductor layer 30, which remains attached to the dielectric layer 22, may be polished after the semiconductor substrate 24 is cleaved. In an embodiment, the semiconductor layer 30, after polishing, may have a thickness suitable to fabricate fully-depleted silicon-on-insulator device structures. In an embodiment, the semiconductor layer 30 may have a thickness within a range of about four (4) nanometers to about twenty (20) nanometers. The dielectric layer 22 is positioned between the semiconductor layer 30 and the semiconductor layer 20. The dielectric layer 22 is positioned between the semiconductor layer 20 and the semiconductor layer 30.

With reference to FIG. 4 and at a fabrication stage subsequent to FIG. 3, shallow trench isolation regions 32 and a deep trench isolation region 34 may be formed by patterning trenches with lithography and etching processes, depositing a dielectric material, such as silicon dioxide, silicon nitride, or another oxide or nitride, that is an electrical insulator in the trenches, and planarizing and/or recessing the deposited dielectric material. The deep trench isolation region 34 may extend to a greater depth than the shallow trench isolation regions 32. In an embodiment, the shallow trench isolation regions 32 may extend fully through the semiconductor layer 30 and the dielectric layer 22, and then extend partially through the semiconductor layer 20. In an embodiment, the deep trench isolation region 34 may extend fully through the semiconductor layer 30, the dielectric layer 22, the semiconductor layer 20, the dielectric layer 18, the conductor layer 16, and the dielectric layer 14, and then extend to a shallow depth into the substrate 12.

The deep trench isolation region 34 effectively divides the conductor layer 16 into a section 35 and a section 36 that is adjacent to the section 35. The deep trench isolation region 34 includes a portion laterally between the section 35 of the conductor layer 16 and the section 36 of the conductor layer 16. The deep trench isolation region 34 also effectively divides the semiconductor layer 30 into a device region 37 and a device region 38. The deep trench isolation region 34 includes a portion that is arranged laterally between the device region 37 of the semiconductor layer 30 and the device region 38 of the semiconductor layer 30. The deep trench isolation region 34 includes a portion that is arranged laterally between a section of the semiconductor layer 20 beneath the device region 37 and a section of semiconductor layer 20 beneath the device region 38. The deep trench isolation region 34 also includes a portion that is arranged laterally between the sections of the dielectric layer 18 respectively above the sections 35, 36 of the conductor layer 16 and a portion that is arranged laterally between the sections of the dielectric layer 14 below the sections 35, 36 of the conductor layer 16.

The section of the semiconductor layer 20 beneath the device region 37 of the semiconductor layer 30 overlaps with the section 35 of the conductor layer 16. The section of the dielectric layer 18 functions as an isolation layer between the section 35 of the conductor layer 16 and the section of the semiconductor layer 20 beneath the device region 37 of the semiconductor layer 30. The device region 37 of the semiconductor layer 30 overlaps with the section of the semiconductor layer 20 beneath the device region 37 and a section of the dielectric layer 22 is positioned between the device region 37 of the semiconductor layer 30 and the overlapped section of the semiconductor layer 20. A section of the dielectric layer 14 functions as an isolation layer between the section 35 of the conductor layer 16 and the substrate 12.

The section of the semiconductor layer 20 beneath the device region 38 of the semiconductor layer 30 overlaps with the section 36 of the conductor layer 16. The section of the dielectric layer 18 functions as an isolation layer between the section 36 of the conductor layer 16 and the section of the semiconductor layer 20 beneath the device region 38 of the semiconductor layer 30. The device region 38 of the semiconductor layer 30 overlaps with the section of the semiconductor layer 20 beneath the device region 38 and a section of the dielectric layer 22 is positioned between the device region 38 of the semiconductor layer 30 and the overlapped section of the semiconductor layer 20. A section of the dielectric layer 14 functions as an isolation layer between the section 36 of the conductor layer 16 and the substrate 12.

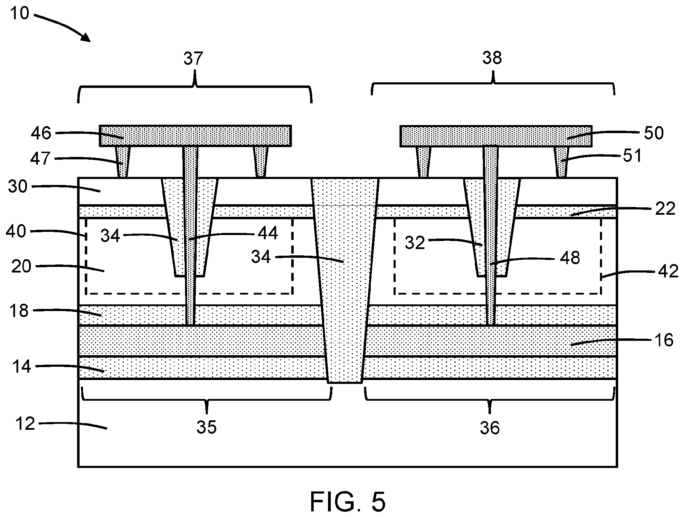

With reference to FIG. 5 and at a fabrication stage subsequent to FIG. 4, a well 40 may be formed in the section of the semiconductor layer 20 beneath the device region 37. In an embodiment, the well 40 may contain a concentration of an n-type dopant, such as phosphorus, to provide n-type conductivity. The well 40 may be formed by implanting ions, such as ions including the n-type dopant, with an implantation mask having an opening defining the intended location for the well 40 in the semiconductor layer 20. The implantation conditions, such as ion species, dose, and kinetic energy, may be selected to tune the electrical and physical characteristics of the well 40.

A well 42 may be formed in the section of the semiconductor layer 20 beneath the device region 38. **In** an embodiment, the well 42 may contain a concentration of a p-type dopant, such as boron, to provide p-type conductivity. The well 42 may be formed by implanting ions, such as ions including the p-type dopant, with an implantation mask having an opening defining the intended location for the well 42 in the semiconductor layer 20. The implantation conditions, such as ion species, dose, and kinetic energy, may be selected to tune the electrical and physical characteristics of the well 42.

A contact 44 may be formed that extends through the shallow trench isolation region 32 in the device region 37 to the section 35 of the conductor layer 16 beneath the device region 37. The contact 44 may electrically and physically connect the section 35 of the conductor layer 16 beneath the device region 37 to a metal feature 46 in the back-end-of-line stack. The metal feature 46 may be electrically and physically connected by contacts 47 to portions of the semiconductor layer 30 in the device region 37. **In** an embodiment, the portions of the semiconductor layer 30 in the device region 37 may include source regions and/or drain regions of one or more field-effect transistors.

A contact 48 may be formed that extends through the shallow trench isolation region 32 in the device region 38 to the section 36 of the conductor layer 16 beneath the device region 38. The contact 48 may electrically and physically connect the section 36 of the conductor layer 16 beneath the device region 38 to a metal feature 50 in the back-end-of-line stack. The metal feature 50 may be electrically and physically connected by contacts 51 to portions of the semiconductor layer 30 in the device region 38. **In** an embodiment, the portions of the semiconductor layer 30 in the device region 38 may include source regions and/or drain regions of one or more field-effect transistors.

The contacts 44, 48 and the contacts 47, 51 may be formed in a dielectric layer that is applied over the device regions 37, 38. The metal features 46, 50 may be formed in a dielectric layer of a metallization level of a back-end-of-line stack that is formed over the dielectric layer in which the contacts 44, 48 and the contacts 47, 51 are formed. Although not shown, the contacts 44, 48 may be electrically isolated from the sections of the semiconductor layer 20 between the shallow trench isolation regions 32 and the dielectric layer 18 by a liner comprised of an electrical insulator.

The one or more field-effect transistors in the device region 37 and the one or more field-effect transistors in the device region 38 may be used to form fully-depleted silicon-on-insulator logic devices. In an embodiment, the section 35 of the conductor layer 16 in the device region 37 and the section 36 of the conductor layer 16 in the device region 38, which are separated by a portion of the deep trench isolation region 34, may be used as buried power rails for the one or more field-effect transistors in the device region 37 and the one or more field-effect transistors in the device region 38, which may eliminate the need for power rails in the back-end-of-line stack. A portion of the deep trench isolation region 34 laterally separates the well 40 from the oppositely-doped well 42 such that the wells 40, 42 do not adjoin along a boundary, which enables forward and reverse body biases to be applied without significant limitations.

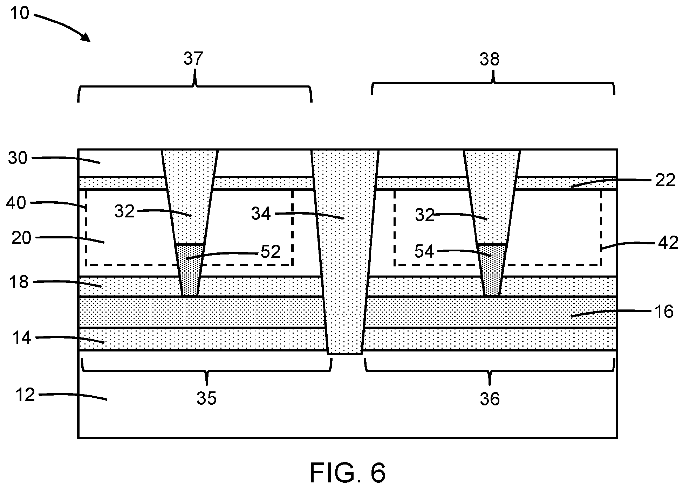

With reference to FIG. 6 and in accordance with alternative embodiments, the trenches for the shallow trench isolation regions 32 may be extended in depth fully through the semiconductor layer 20 and the dielectric layer 18 to the conductor layer 16. Conductor layers 52, 54 may be formed in lower portions of the trenches, followed by the formation of the dielectric material that comprises the shallow trench isolation regions 32 in the upper portions of the trenches. The conductor layers 52, 54 are positioned between the dielectric material of the shallow trench isolation regions 32 and the conductor layer 16. The conductor layers 52, 54 are comprised of a conductive material, such as doped polysilicon or a metal, and may be comprised of the same conductive material as the conductor layer 16.

The conductor layer 52 represents a buried interconnect that electrically and physically couples the section 35 of the conductor layer 16 beneath the device region 37 and the well 40 to the section 36 of the semiconductor layer 20 beneath the device region 37. The conductor layer 54 represents a buried interconnect that electrically and physically couples the section of the conductor layer 16 beneath the device region 38 and the well 42 to the section of the semiconductor layer 20 beneath the device region 38. The buried interconnects represented by the conductor layers 52, 54 may be utilized to apply forward and reverse body biases to the wells 40, 42.

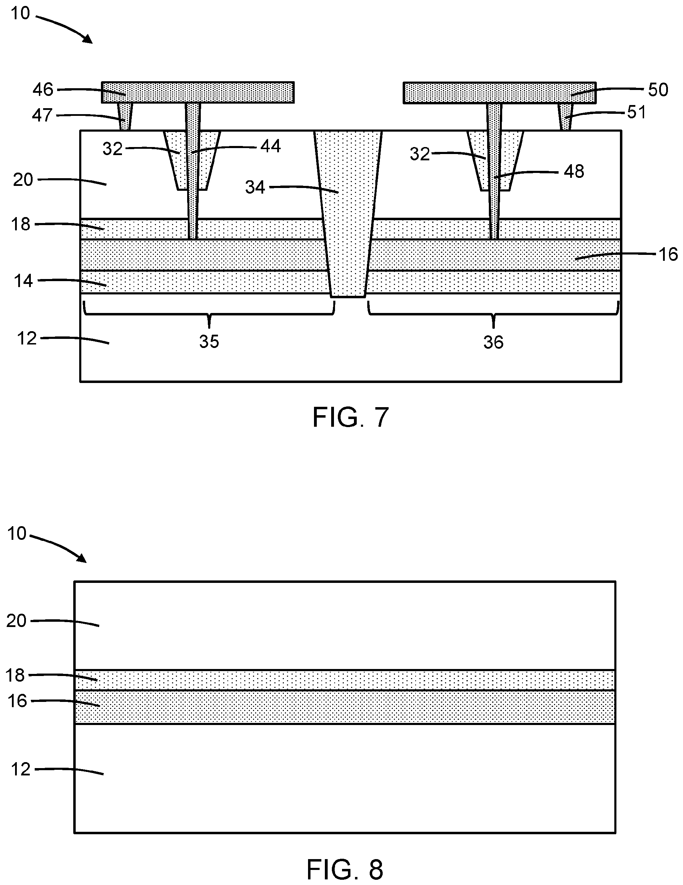

With reference to FIG. 7 and in accordance with alternative embodiments, the semiconductor layer 30 and the dielectric layer 22 may be removed from the structure 10. The metal feature 46 may be electrically and physically connected by the contact 44 to a section of the conductor layer 16 and by the contact 47 to a section of the semiconductor layer 20. The metal feature 50 may be electrically and physically connected by the contact 48 to a section of the conductor layer 16 and by the contact 51 to a section of the semiconductor layer 20. The sections of the semiconductor layer 20 may include source regions and/or drain regions of one or more bulk field-effect transistors. The conductor layer 16 may function as a heat sink to extract heat generated by the field-effect transistors. Forming the dielectric layer 18 from a dielectric material having a comparatively high thermal conductivity, such as aluminum oxide, may improve the efficiency of the conductor layer 16 as a heat sink.

With reference to FIG. 8 and in accordance with alternative embodiments, the substrate 12 may be comprised of a dielectric material, such as glass or sapphire, that is an electrical insulator. The dielectric layer 14 may be omitted and the conductor layer 16 may directly contact the substrate 12 because of the selection of an electrical insulator for the substrate 12. Processing continues as described in connection with FIGS. 2-5.

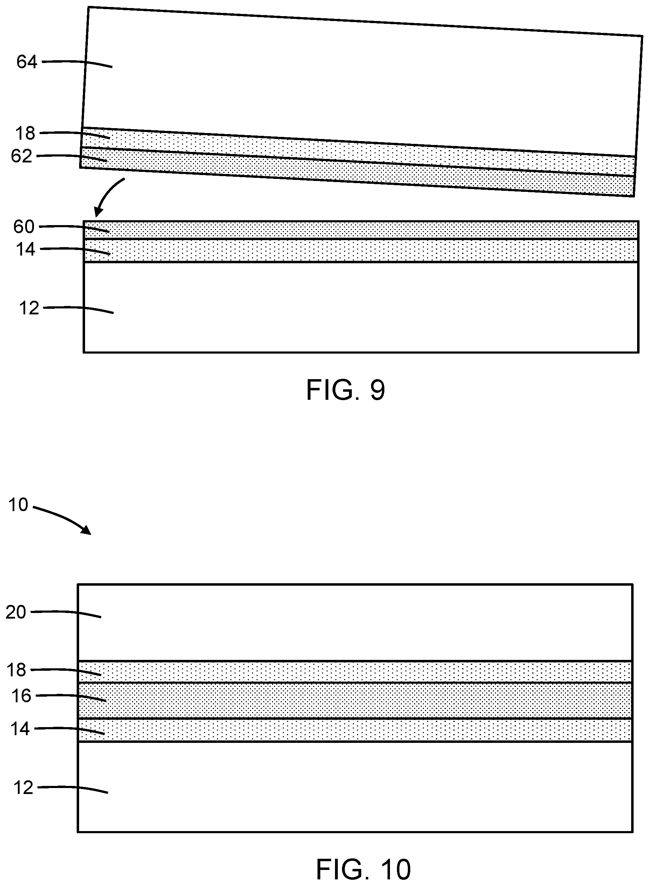

With reference to FIG. 9 and in accordance with alternative embodiments, the dielectric layer 14 and a conductor layer 60 may be initially positioned on the substrate 12, and the dielectric layer 18 and a conductor layer 62 may be initially positioned on a substrate 64. The conductor layers 60, 62 may be comprised of a conductor material, such as a metal or a metal nitride, that is electrically conductive. In an embodiment, the metal contained in the conductor layers 60, 62 may be tungsten deposited by atomic layer deposition or chemical vapor deposition. The conductor layers 60, 62 may be placed in a face-to-face contacting relationship. The substrate 64 may be comprised of a semiconductor material, such as silicon.

With reference to FIG. 10 and at a fabrication stage subsequent to FIG. 9, the conductor layers 60, 62 may be bonded together by a direct bonding technique and consolidated to form the conductor layer 16. After bonding, the substrate 64 may be thinned by, for example backside grinding, to form the semiconductor layer 20. Processing continues as described in connection with FIGS. 2-5.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value or precise condition as specified. In embodiments, language of approximation may indicate a range of +/-10% of the stated value(s) or the stated condition(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction in the frame of reference perpendicular to the horizontal plane, as just defined. The term "lateral" refers to a direction in the frame of reference within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features may "overlap" if a feature extends over, and covers a part of, another feature. A feature may "overlie" another feature if a feature is positioned "over" another feature.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

**In** summary, semiconductor structures that include a conductor layer and multiple dielectric layers, as well as methods of forming such semiconductor structures are provided. The structure comprises a first dielectric layer, a second dielectric layer, and a conductor layer including a first section and a second section between the first dielectric layer and the second dielectric layer. The structure further comprises a semiconductor layer including a first section that overlaps with the first section of the conductor layer and a second section that overlaps with the second section of the conductor layer, and a trench isolation region including a first portion laterally between the first section of the conductor layer and the second section of the conductor layer.

The following embodiments are explicitly disclosed.

### Embodiment 1:

A structure comprising:
a first dielectric layer;
a second dielectric layer;
a conductor layer including a first section and a second section between the first dielectric layer and the second dielectric layer;
a first semiconductor layer including a first section that overlaps with the first section of the conductor layer and a second section that overlaps with the second section of the conductor layer; and
a first trench isolation region including a first portion laterally between the first section of the conductor layer and the second section of the conductor layer.

### Embodiment 2:

The structure of embodiment 1, wherein the first trench isolation region includes a second section laterally between the first section of the first semiconductor layer and the second section of the first semiconductor layer.

### Embodiment 3:

The structure of embodiment 1 o 2, further comprising:
a second semiconductor layer having a first device region that overlaps with the first section of the first semiconductor layer and a second device region that overlaps with the second section of the first semiconductor layer; and
a third dielectric layer including a first section and a second section, the first section of the third dielectric layer between the first device region and the first section of the first semiconductor layer, and the second section of the third dielectric layer between the second device region and the second section of the first semiconductor layer.

### Embodiment 4:

The structure of embodiment 3, wherein the first trench isolation region includes a second section laterally between the first device region and the second device region.

### Embodiment 5:

The structure of embodiment 3 or 4, further comprising:
a first contact coupled to the first section of the conductor layer.

### Embodiment 6:

The structure of embodiment 5, further comprising:
a second contact coupled to a portion of the first device region; and
a metal feature coupled by the first contact to the first section of the conductor layer and by the second contact to the portion of the first device region.

### Embodiment 7:

The structure of embodiment 5 or 6, further comprising:
a second trench isolation region extending through the first device region and the first section of the third dielectric layer into the first section of the first semiconductor layer,
wherein the first contact extends fully through the second trench isolation region.

### Embodiment 8:

The structure of embodiment 7, wherein the second trench isolation region extends partially through the first section of the first semiconductor layer.

### Embodiment 9:

The structure of one of embodiments 5 to 8, further comprising:
a second contact coupled to the second section of the conductor layer.

### Embodiment 10:

The structure of embodiment 9, further comprising:
a second trench isolation region extending through the first device region and the first section of the second dielectric layer into the first section of the first semiconductor layer; and
a third trench isolation region extending through the second device region and the second section of the third dielectric layer into the second section of the first semiconductor layer,
wherein the first contact extends fully through the second trench isolation region, and the second contact extends fully through the third trench isolation region.

### Embodiment 11:

The structure of one of embodiments 1 to 10, further comprising:
a second trench isolation region in the first section of the first semiconductor layer; and
a buried interconnect between the second trench isolation region and the first section of the conductor layer, the buried interconnect coupling the first section of the first semiconductor layer to the first section of the conductor layer.

### Embodiment 12:

The structure of embodiment 11, further comprising:
a well in the first section of the first semiconductor layer.

### Embodiment 13:

The structure of one of embodiments 1 to 12, further comprising:
a first contact coupled to the first section of the conductor layer.

### Embodiment 14:

The structure of embodiment 13, further comprising:
a second contact coupled to a portion of the first section of the first semiconductor layer; and
a metal feature coupled by the first contact to the first section of the conductor layer and by the second contact to the portion of the first section of the first semiconductor layer.

### Embodiment 15:

The structure of embodiment 14, further comprising:
a second trench isolation region extending into the first section of the first semiconductor layer,
wherein the first contact extends fully through the second trench isolation region.

### Embodiment 16:

The structure of one of embodiments 1 to 15, wherein the conductor layer comprises tungsten.

### Embodiment 17:

The structure of one of embodiments 1 to 16, wherein the first dielectric layer includes a first section between the first section of the conductor layer and the first section of the first semiconductor layer, the first dielectric layer includes a second section between the second section of the conductor layer and the second section of the first semiconductor layer.

### Embodiment 18:

The structure of one of embodiments 1 to 17 wherein the first dielectric layer comprises aluminum oxide.

### Embodiment 19:

The structure of one of embodiments 1 to 18, further comprising:
a substrate,
wherein the second dielectric layer includes a first section between the first section of the conductor layer and the substrate, and the second dielectric layer includes a second section between the second section of the conductor layer and the substrate.

### Embodiment 20:

A method comprising:
forming a layer stack including a first dielectric layer, a second dielectric layer, a conductor layer between the first dielectric layer and the second dielectric layer, and a semiconductor layer on the second dielectric layer; and
forming a trench isolation region that divides the conductor layer into a first section and a second section,
wherein the trench isolation region includes a first portion laterally between the first section of the conductor layer and the second section of the conductor layer, and the semiconductor layer includes a first section that overlaps with the first section of the conductor layer and a second section that overlaps with the second section of the conductor layer.

### Embodiment 21:

The method of embodiment 20, wherein the structure of one of embodiments 1 to 19 is formed.

## Claims

1. A structure comprising:
a first dielectric layer, wherein the first dielectric layer preferably comprises aluminum oxide;
a second dielectric layer;
a conductor layer including a first section and a second section between the first dielectric layer and the second dielectric layer, wherein the conductor layer preferably comprises tungsten;
a first semiconductor layer including a first section that overlaps with the first section of the conductor layer and a second section that overlaps with the second section of the conductor layer; and
a first trench isolation region including a first portion laterally between the first section of the conductor layer and the second section of the conductor layer.

2. The structure of claim 1, wherein the first trench isolation region includes a second section laterally between the first section of the first semiconductor layer and the second section of the first semiconductor layer.

3. The structure of claim 1 or 2, further comprising:
a second semiconductor layer having a first device region that overlaps with the first section of the first semiconductor layer and a second device region that overlaps with the second section of the first semiconductor layer; and
a third dielectric layer including a first section and a second section, the first section of the third dielectric layer between the first device region and the first section of the first semiconductor layer, and the second section of the third dielectric layer between the second device region and the second section of the first semiconductor layer.

4. The structure of claim 3, wherein the first trench isolation region includes a second section laterally between the first device region and the second device region.

5. The structure of claim 3, further comprising:
a first contact coupled to the first section of the conductor layer.

6. The structure of claim 5, further comprising:
a second contact coupled to a portion of the first device region; and
a metal feature coupled by the first contact to the first section of the conductor layer and by the second contact to the portion of the first device region.

7. The structure of claim 5 or 6, further comprising:
a second trench isolation region extending through the first device region and the first section of the third dielectric layer into the first section of the first semiconductor layer,
wherein the first contact extends fully through the second trench isolation region,
wherein the second trench isolation region preferably extends partially through the first section of the first semiconductor layer.

8. The structure of claim 5, further comprising:
a second contact coupled to the second section of the conductor layer.

9. The structure of claim 8, further comprising:
a second trench isolation region extending through the first device region and the first section of the second dielectric layer into the first section of the first semiconductor layer; and
a third trench isolation region extending through the second device region and the second section of the third dielectric layer into the second section of the first semiconductor layer,
wherein the first contact extends fully through the second trench isolation region, and the second contact extends fully through the third trench isolation region.

10. The structure of claim **1,** further comprising:
a second trench isolation region in the first section of the first semiconductor layer; and
a buried interconnect between the second trench isolation region and the first section of the conductor layer, the buried interconnect coupling the first section of the first semiconductor layer to the first section of the conductor layer,
wherein the structure preferably further comprises a well in the first section of the first semiconductor layer.

11. The structure of claim 5, further comprising:
a second contact coupled to a portion of the first section of the first semiconductor layer; and
a metal feature coupled by the first contact to the first section of the conductor layer and by the second contact to the portion of the first section of the first semiconductor layer.

12. The structure of claim **11,** further comprising:
a second trench isolation region extending into the first section of the first semiconductor layer,
wherein the first contact extends fully through the second trench isolation region.

13. The structure of one of claims 1 to 12, wherein the first dielectric layer includes a first section between the first section of the conductor layer and the first section of the first semiconductor layer, the first dielectric layer includes a second section between the second section of the conductor layer and the second section of the first semiconductor layer.

14. The structure of one of claims 1 to 13, further comprising:
a substrate,
wherein the second dielectric layer includes a first section between the first section of the conductor layer and the substrate, and the second dielectric layer includes a second section between the second section of the conductor layer and the substrate.

15. A method comprising:
forming a layer stack including a first dielectric layer, a second dielectric layer, a conductor layer between the first dielectric layer and the second dielectric layer, and a semiconductor layer on the second dielectric layer; and
forming a trench isolation region that divides the conductor layer into a first section and a second section,
wherein the trench isolation region includes a first portion laterally between the first section of the conductor layer and the second section of the conductor layer, and the semiconductor layer includes a first section that overlaps with the first section of the conductor layer and a second section that overlaps with the second section of the conductor layer.
